# EUROPÄISCHE PATENTSCHRIFT

(11) **EP 2 877 610 B1**
(45) Veröffentlichungstag und Bekanntmachung des Hinweises auf die Patenterteilung: **11.05.2016**
(21) Anmeldenummer: 13739717.0
(22) Anmeldetag: 23.07.2013
(51) Int. Cl.: C23C 14/56, C23C 16/44, C23C 16/455, C23C 16/54

(54) **GASSEPARATION**
GAS SEPARATION
SÉPARATION DE GAZ

(30) Priorität: 25.07.2012 DE 102012213095
(43) Veröffentlichungstag der Anmeldung: 03.06.2015
(73) Patentinhaber: Meyer Burger (Germany) AG, 09337 Hohenstein-Ernstthal (DE)
(72) Erfinder: MAI, Joachim, 04603 Nobitz (DE); DECKER, Daniel, 09427 Ehrenfriedersdorf (DE); HELBIG, Stefan, 04626 Schmölln (DE); LOEWEL, Oliver, 09355 Gersdorf (DE)
(74) Vertreter: Kailuweit & Uhlemann Patentanwälte Partnerschaft mbB
(86) Internationale Anmeldenummer: PCT/EP2013/065513
(87) Internationale Veröffentlichungsnummer: WO 2014/016297

(56) Entgegenhaltungen:
- DE-B4-102008 026 001
- US-A1- 2003 143 134

## Beschreibung

Gegenstand der vorliegenden Erfindung ist eine Vorrichtung zur Gasbewegung, insbesondere zur Gasabsaugung für Gasatmosphären in Anlagen für Beschichtungen auf Substraten.

Die Beschichtung von Substraten mit dünnen Schichten eines Elements oder mit Verbindungen erfolgt in der Solar- und Halbleiterindustrie häufig mit PECVD-Verfahren (plasma enhanced chemical vapour deposition) oder mit PVD- Verfahren (physical vapour deposition). Dabei kommen Sputtern, thermisches Verdampfen, Laser- und Ionenstrahlverdampfen, Plasmabeschichtungen und weitere, aus dem Stand der Technik bekannte Verfahren zum Einsatz. Durchgeführt werden diese Verfahren häufig in Durchlaufanlagen, die als Vakuumkammern ausgebildete Bearbeitungskammern aufweisen, durch die die zu beschichtenden Substrate kontinuierlich oder diskontinuierlich (schrittweise) hindurchbewegt und dabei beschichtet werden.

Die Beschichtungs- oder sonstigen Arbeitsmaterialien liegen häufig gasförmig vor. So können sich Anteile, die nicht auf dem Substrat niedergeschlagen werden, unkontrolliert in der Behandlungskammer ausbreiten. Es ist daher wünschenswert, diese Gase kontrolliert abzusaugen, ohne dass etwaige Strömungsprofile den Beschichtungs- bzw. Bearbeitungsprozess stören.

Häufig werden mehrere Schichten unterschiedlicher Materialien unmittelbar aufeinanderfolgend auf ein Substrat aufgebracht. In solchen Fällen ist es vorteilhaft, wenn keine aufwendigen Ein- und Ausschleusungsvorgänge in unterschiedliche Behandlungskammern notwendig sind, sondern wenn die aufeinanderfolgenden Beschichtungen in ein und derselben Behandlungskammer vorgenommen werden können. Problematisch dabei kann es sein, wenn die verschiedenen Beschichtungsmaterialien miteinander nicht verträglich sind und bspw. unerwünscht miteinander reagieren oder Bestandteile eines Beschichtungsmaterials in der Schicht eines anderen Materials als Verunreinigung wirken.

Es gibt eine Reihe von technischen Ansätzen, dieses Problem zu lösen. Neben kleinerer Zwischenschleusen und beweglichen Abgrenzungen hat es sich insbesondere durchgesetzt, die Überströmung von gasförmigen Materialien aus einem Kammerbereich in einen anderen zu verhindern. Dazu wird, bevorzugt an den Grenzen der Behandlungsbereiche der Gasstrom angesaugt und so eine Trennung der Bereiche erreicht.

Die WO2007/059749 beschreibt ein System mit kleinen Zwischenschleusen, durch die die Substrate über das Transportsystem bewegt werden, und die Klappen aufweisen, die die Eingangs bzw. Ausgangsöffnung der Zwischenschleusen wechselseitig abdecken. Im Schleusenbereich erfolgt eine Absaugung, um mitgeführte Gasreste zu entfernen.

In der DD214865A1 wird beschrieben, wie die Trennung zwischen zwei Beschichtungsbereichen in denen mit Plasmatrons gearbeitet wird, von denen ein erster ein hochreaktives und der zweite ein wenig reaktives Arbeitsgas aufweist, eine Trennung erzielt wird, indem der Druck des wenig reaktiven Gases erhöht wird. Darüber hinaus wird zwischen den beiden Bereichen eine Absaugung vorgesehen. Auf diese Weise wird verhindert, dass das hochreaktive Gas in den zweiten Bereich vordringt.

In der DE4303462A1 wird eine Beschichtungsanlage für Glassubstrate offenbart, in der die Glassubstrate liegend im Durchlauf von oben beschichtet werden. Auch hier erfolgt die Trennung von Beschichtungsbereichen, indem zwischen diesen Absaugungen vorgesehen werden. In der beschriebenen Lösung wird einmal nach unten von der Unterseite der Substrate her abgesaugt und in weiteren Ausführungsformen zwischen den Beschichtungsbereichen gleichzeitig seitlich zu den Targets, von denen das Beschichtungsmaterial abgetragen wird. Dazu kommen Zwischenwände zum Einsatz, die gemeinsam mit den weiteren Bauelementen der Beschichtungskammer einen rohrartigen, im Querschnitt rechteckigen, Hohlraum ausbilden. Dieser Hohlraum weist einen Schlitz als Gaseinlass auf, der auf die Seite gerichtet ist, auf der sich das Target befindet. Der Hohlraum wird an seinem Enden, an der Seitenwand der Beschichtungskammer mittels Vakuumpumpe evakuiert.

Den beiden Vorrichtungen nach DD214865A1 und DE4303462A1 ist gemeinsam, dass die Absaugung von Gas aus den Beschichtungskammern erfolgt, ohne Rücksicht auf die entstehenden Strömungsverhältnisse zu nehmen. So ist damit zu rechnen, dass in der Nähe der Pumpenöffnung ein sehr viel stärkerer Gasstrom entsteht, als in einiger Entfernung. Da die Pumpen typischerweise in der Seitenwandung der Behandlungskammer oder ober bzw. unterhalb des Substrates angeordnet sind, ist ein über das gesamte Substrat gleichmäßigerer Gasstrom, der vermeidet, den stattfindenden Beschichtungsprozess wenig zu beeinflussen, nicht zu erwarten.

Die DE102010028734A1 sieht vor, eine Gasseparation zwischen zwei Beschichtungsbereichen zu realisieren, indem direkt oberhalb der Substratoberfläche durch eine Öffnung abgesaugt wird, die von Blechen flankiert ist, die parallel zur Substratoberfläche ausgerichtet sind und einen Strömungswiderstand bilden sollen. Da der Druckverlust um diese Strömungswiderstandsbleche herum sehr viel größer ist, als der Druckverlust, der hinter diesen auftritt, vermeinen die Erfinder, eine Vergleichmäßigung des Strömungsbildes über die gesamte Länge der Absaugvorrichtung zu erreichen. Die Länge der Absaugvorrichtung ist dabei senkrecht zur Transportrichtung der Substrate und parallel zu deren Oberfläche zu sehen. Die Absaugung erfolgt durch Vakuumpumpen, die oberhalb der Substrate angeordnet sind.

DE 10 2008 026 001 B4 beansprucht ein Verfahren zur Herstellung einer Prozessatmosphäre in Durchlaufbeschichtungsanlagen. Insbesondere ist vorgesehen, dass in der Beschichtungsanlage mindestens zwei Beschichtungsbereiche existieren, die unterschiedliche Gasatmosphären aufweisen können. Die Trennung der Gasatmosphären erfolgt, indem in jedem Beschichtungsbereich eine Gaszufuhr und eine Gasabsaugung existiert. Darüber hinaus ist beschrieben, dass die Gasabsaugung als *"Gaskanal* (16), *der sich quer zur Transportrichtung (3) des Substrats (1) über die Substratbreite erstreckt und zumindest eine Öffnung (20) aufweist,* so *dass eine Gasströmung (22) zwischen Substrat (1) und Gaskanal* (16) *und über die Substratbreite verteilt zu erzeugen ist.* Es ist vorgesehen, dass sich auf einer Seite der Beschichtungsquelle ein Gaskanal zur Gaszuführung und auf der anderen Seite zur Gasabsaugung befindet.

US 2003/01433134 A1 offenbart eine Vorrichtung, wobei eine Gasabführleitung quer zur Transportrichtung des Substrats angeordnet wird. Die im Stand der Technik übliche Anordnung von Vakuumpumpen direkt oberhalb der Substrate verhindert einen Aufbau, der mehrere Behandlungsbereiche übereinander vorsieht. Darüber hinaus verursacht die Absaugung durch den Spalt, der zwischen Substrat und Strömungsleitblechen entsteht, eine stark inhomogene Strömung, die zu einer ungleichmäßigen Beschichtung der Substratoberfläche führen kann. Besonders bei Plasmaprozessen, wie z.B. beim Plasmaätzen oder auch einem PECVD-Prozess haben im Plasma erzeugte Abbauprodukte bzw. Gasteilchen teilweise die Eigenschaft auch in entfernteren Bereichen außerhalb des definierten Bearbeitungsgebietes Reaktionen mit den Substratoberflächen auslösen zu können. Das kann zu nachteiligen Veränderungen der Oberflächeneigenschaften, wie z.B. Veränderungen der Homogenität oder auch der Passivierungsqualität oder optischen Eigenschaften usw. führen.
Es stellt sich somit die Aufgabe, eine Gasabsaugvorrichtung vorzuschlagen, die in einer Beschichtungskammer eine definierte Gasbewegung ermöglicht, ohne durch starke Strömungsunterschiede in der Beschichtungskammer die Ausbildung gleichmäßig dicker homogener Schichten zu behindern oder die durch gezielte Strömungsunterschiede in kontrollierbarer Weise die Schichtbildung beeinflusst.
Erfindungsgemäß gelöst wird diese Aufgabe mit der Vorrichtung nach Anspruch 1. Vorteilhafte Ausführungsformen sind in den rückbezogenen Unteransprüchen offenbart.

Die Beschichtungseinrichtungen für Substrate sind meist annähernd linear ausgedehnt und parallel zur Substratoberfläche sowie senkrecht zur Transportrichtung des Substrates angeordnet. Das Substrat wird bevorzugt mit kontinuierlicher Geschwindigkeit unter bzw. über ihnen transportiert. Die Ablagerung des Beschichtungsmaterials erfolgt während dieser Transportbewegung. Damit die Beschichtung gleichmäßig ist, entspricht die Länge der Beschichtungsvorrichtungen mindestens der Breite der Substrate bzw. der Substratträger, in denen die Substrate transportiert werden. Somit entsteht auch über die gesamte Länge der Beschichtungsvorrichtungen gasförmiges Material, dass sich nicht vollständig niederschlägt und abgesaugt werden muss.

Die erfindungsgemäße Vorrichtung weist mindestens eine Beschichtungskammer mit mindestens einem Beschichtungsbereich auf. Sie weist weiterhin eine Transportvorrichtung zum Transport flächiger Substrate in eine Transportrichtung in die Beschichtungskammer und zur Halterung der Substrate in dieser auf. In der Beschichtungskammer existiert mindestens eine Beschichtungsvorrichtung je Beschichtungsbereich. Die Beschichtungsvorrichtung sondert gasförmiges Beschichtungsmaterial ab. Ihre Länge entspricht dabei mindestens der Breite des Substrats. Es existiert mindestens eine Absaugvorrichtung je Beschichtungsbereich, wobei die Absaugvorrichtung sich im Wesentlichen parallel zu der Beschichtungsvorrichtung erstreckt und mindestens deren Länge aufweist. An die Absaugvorrichtung ist mindestens eine Pumpe angeschlossen, die im Inneren der Absaugvorrichtung einen Unterdruck gegenüber den Innendruck der Beschichtungskammer erzeugt. Insbesondere ist die mindestens eine Pumpe in axialer Verlängerung der Absaugvorrichtung an diese angeschlossen. Die Absaugvorrichtung weist eine oder mehrere Ansaugöffnungen auf und ist in mindestens zwei axiale Bereiche aufgeteilt, deren Absaugcharakteristika weitgehend getrennt voneinander einstellbar sind. Die Ansaugöffnungen sind bevorzugt so angeordnet, dass der Strom angesaugten Gases parallel zur Substratoberfläche verläuft und nicht senkrecht zu dieser. dazu liegen die Ansaugöffnungen besonders bevorzugt in einer Ebene, die senkrecht zur Substratoberfläche verläuft.

Die Absaugvorrichtung ist bevorzugt als Rohr-in-Rohr-Konstruktion ausgebildet. Sie weist somit ein Innenrohr und ein Außenrohr auf. Die Rohrquerschnitte können dabei identisch oder unterschiedlich sein. Bevorzugt weisen Innen- und Außenrohr einen runden Querschnitt auf. In einer weiteren bevorzugten Ausführungsform sind die Querschnitte rechteckig oder annähernd rechteckig mit abgerundeten Ecken. Die Anfertigung der Rohre kann dabei auch durch das Zusammenfügen einzelner Teilformen, wie Halbschalen, U-Blechen und sonstigen Blechformteilen erreicht werden.

Das Innenrohr weist einen Außendurchmesser auf, der geringer als der Innendurchmesser des Außenrohres ist. Die Pumpe bzw. die Pumpen sind an das Innenrohr, bevorzugt an dessen Stirnflächen angeschlossen. Das Innenrohr weist eine oder mehrere Einsaugöffnungen auf, durch die Gas aus dem Zwischenraum zwischen Außenseite des Innenrohres und Innenseite des Außenrohres eingesaugt wird. In einer bevorzugten Ausführungsform sind die Einsaugöffnungen in Ihrer Öffnungsweite veränderbar. Dies wird bspw. durch Blenden realisiert, die durch mindestens ein weiteres Rohr (Blendenrohr), dass eng an die Innen- oder Außenwandung des Innenrohrs anliegt und verdrehbar- und oder verschiebbar gegenüber diesem ist und dabei Öffnungen aufweist, die die Einsaugöffnungen teilweise verschließen. Bei der Nutzung mehrerer (mindestens zwei) solcher Blendenrohre kann vorteilhaft die Ansaugcharakteristik der Einsaugöffnungen abhängig von ihrer axialen Position bestimmt werden.

In einer weiteren bevorzugten Ausführungsform weist das Innenrohr eine Trennwand auf, die es in zwei Ansaugbereiche für jeweils mindestens eine, an den Stirnflächen absaugende, Pumpe aufteilt. Weiterhin bevorzugt ist, diese Trennwand verschiebbar vorzusehen.

In einer weiteren bevorzugten Ausführungsform ist das Innenrohr tordierbar, d. h. das Innenrohr kann um seine Längsachse in Umfangsrichtung verdrillt werden. Dazu wird das Innenrohr an einem Ende fixiert, während das andere Ende verdreht wird. Dadurch verändert sich die Position der Einsaugöffnungen und das erzeugte Strömungsprofil im Zwischenraum. In einer weiteren bevorzugten Ausführungsform wird das Innenrohr mittig gehalten und die beiden Enden können verdreht werden. Die mittige Halterung erfolgt vorzugsweise durch eine starre Trennwand, die das Innenrohr mit dem Außenrohr verbindet.

In einer weiteren bevorzugten Ausführungsform ist das Innenrohr über eine oder mehrere Trennwände mit dem Außenrohr verbunden. die so entstehenden Innenrohrabschnitte sind einzeln in Ihrer Ausrichtung veränderbar (axial verdrehbar).

Das Außenrohr weist die Ansaugöffnungen auf, durch die Gas aus der Beschichtungskammer in den Zwischenraum zwischen Außenseite des Innenrohres und Innenseite des Außenrohres angesaugt wird. Bevorzugt sind die Einsaugöffnungen des Innenrohres von den Ansaugöffnungen des Außenrohres weg gerichtet. Bereits diese Maßnahme führt dazu, dass Strömungsungleichmäßigkeiten, die durch den Druckverlust im Innenrohr hervorgerufen werden und zu einem ungleichmäßigen Ansaugdruck im Zwischenraum führen können, teilweise bereits im Zwischenraum ausgeglichen und der Absaugdruck an den Ansaugöffnungen des Außenrohres vergleichmäßigt werden kann.

In einer bevorzugten Ausführungsform weist das Außenrohr auf seiner Außenseite Strömungsleitbleche auf, die in Position und Ausrichtung durch Verschieben oder Verdrehen geändert werden können.

In einer weiteren bevorzugten Ausführungsform weist das Außenrohr Blendenrohre analog zu den beim Innenrohr beschriebenen Ausführungsformen auf.

Weiterhin bevorzugt ist das Außenrohr in mindestens zwei unabhängig voneinander in Umfangsrichtung verdrehbare Abschnitte aufgeteilt. Diese Abschnitte werden durch Zwischenwände, die sie mit dem Innenrohr verbinden abgestützt, oder sind an Haltekonstruktionen angeordnet, die außerhalb des Außenrohres dieses aufnehmen und mit der Wandung der Beschichtungskammer verbinden und dort abstützen. Weiterhin bevorzugt ist, das Außenrohr in seiner gesamten Länge oder abschnittsweise tordierbar vorzusehen. Dazu wird das Außenrohr an einem Ende eingespannt und das andere Ende gegenüber dem ersten verdreht. Eine weitere bevorzugte Ausführungsform sieht eine mittige Halterung (mittels Trennscheibe am Innenrohr oder mittels Haltekonstruktion) vor wodurch dann vorteilhaft die beiden Enden unabhängig voneinander verdreht werden können. In noch einer bevorzugten Ausführungsform wird das tordierbare Außenrohr an beiden Enden eingespannt und zwischen diesen verdreht. die Verdrehung kann dabei mittig angreifen oder auch außermittig, so dass die entstehenden Verdrehungsabschnitte asymmetrisch ausfallen. Vorteilhaft erfolgt dies mittels einer Vorrichtung, die, in ihrem Angriffspunkt in axialer Richtung verschiebbar, an der Außenseite des Außenrohres angreift. Dazu sind bspw. achsenparallele Erhöhungen am Außenrohr vorgesehen, an denen eine Klammer oder Ähnliches angreift.

Die Materialien von Innen- und Außenrohr können gleich oder unterschiedlich sein. Sie sind insbesondere abhängig von den angestrebten Variationsmöglichkeiten der Strömungsgestaltung. So bestehen Innen- bzw. Außenrohre, die lediglich in ihrer Orientierung verändert werden (auch abschnittsweise) vorzugsweise aus Edelstahl oder Aluminiumlegierungen. Tordierbar ausgeführte Rohre sind vorzugsweise aus Gewebe- oder Verbundmaterialien gefertigt. Hier kommen insbesondere Kohlefasergewebe oder Kohlefaserverbundwerkstoffe zum Einsatz. Weiterhin geeignet sind stahlfasergeflochtene Rohre. Prinzipiell geeignet sind die Stoffe aus dem Stand der Technik, die bereits in den Beschichtungsanlagen eingesetzt werden.

Zur Verbesserung der Haftungseigenschaften oder auch zum Schutz der Materialoberflächen gegenüber aggressiven Gasteilchen können diese auch durch Oberflächenvergütungen wie Rauhigkeitsänderungen, Zusatzbeschichtungen oder auch durch zusätzliche Verkleidungs- bzw. Auskleidungsteile an die unterschiedlichen Bearbeitungsprozesse angepasst werden. Die Verkleidungs- bzw. Auskleidungsteile sind bevorzugt Bleche, Folien oder Bänder aus geeigneten Stoffen oder Verbundmaterialien. Die Ausgestaltungsform dieser Teile kann dabei netzartig, gewebeartig, lochblechartig oder andersartig profiliert sein. Damit kann die Standzeit der Vorrichtung verlängert bzw. die Wartung deutliche vereinfacht werden.

Die Absaugvorrichtung weist in einer bevorzugten Ausführungsform mindestens einen Diffusor auf, der eine weitere Vergleichmäßigung der angesaugten Gasströmung bewirkt. Der Diffusor kann sich über Bereiche der Absaugvorrichtung oder die gesamte Absaugvorrichtung erstrecken. Bevorzugt ist der Diffusor als Labyrinthkonstruktion in der Absaugvorrichtung, hier im Zwischenraum zwischen Außenseite des Innenrohres und Innenseite des Außenrohres, ausgebildet. Dabei ist das Labyrinth so gestaltet, dass es in axialer Richtung der Absaugvorrichtung einen Druckverlust aufweist, der sehr viel kleiner ist, als der Druckverlust in Umfangsrichtung. Der Diffusor kann dabei als Anordnung mehrerer kurzer achsenparalleler Strömungsleitbleche ausgebildet sein. Weitere bevorzugte Ausführungsformen sehen eine gelochte oder netzartige achsenparallele Struktur vor, die den Druckverlust in Umfangsrichtung erhöht, wodurch es zu einer Vergleichmäßigung des Drucks Im Zwischenraum zwischen den Einsaugöffnungen und den Diffusorstrukturen kommt.

In einer bevorzugten Ausführungsform sind mehrere Innenrohre in einem Außenrohr angeordnet.

Vorzugsweise werden im Ergebnis von Strömungsberechnungen Kombinationen der oben beschriebenen Maßnahmen verwendet, um ein anforderungsgerechtes Strömungsprofil auszubilden.

So wird vorzugsweise durch ein axiales Verdrehen des Innenrohres gegenüber der Leitblechanordnung die gemeinsame, überlagerte Öffnungsgeometrie beider Öffnungen definiert eingestellt. Damit kann z. B. eine wirkungsvolle Feinkorrektur des Gasströmungswiderstandes und damit auch des Gasströmungsprofiles erreicht werden. Werden nicht deckungsgleiche Öffnungen von Innenrohr und Blendenrohr verwendet, so ist durch ein Verdrehen des Innenrohres und/oder des Blendenrohres auch ein örtlich veränderliches Gaseinsaugprofil vorstellbar. In einer weiteren Ausgestaltungsvariante können auch zusätzliche Einsaugöffnungen z. B. auf weiteren Winkelpositionen und auch axialen Positionen auf dem Mantel des Innerohres verteilt angeordnet sein. Durch ein axiales Verdrehen des Innerohres ist dann sogar ein komplexeres Einstellen von unterschiedlichen Strömungswiderständen und deren Wirkung auf das Gasströmungsprofil einstellbar. Wird das Innenrohr mit einem Drehantrieb versehen, so ist auch eine zeitlich veränderliche Einstellung von Gasströmungsprofilen dieser Gasabsaugung erreichbar.

Die Absaugvorrichtung wird bevorzugt benachbart zu einer Beschichtungsvorrichtung in der Beschichtungskammer angeordnet. Auf diese Weise wird vorteilhaft gewährleistet, dass Beschichtungsgas, welches das Substrat nicht erreicht möglichst vollständig abgesaugt wird und sich nicht unkontrolliert niederschlägt. Auf diese Weise lässt sich vorteilhaft die Standzeit der Anlage zwischen zwei Reinigungszyklen vergrößern.

In einer bevorzugten Ausführungsform wird die Gasabsaugung so eingesetzt, dass diese unmittelbar benachbart zu einer Beschichtungsvorrichtung angeordnet ist, wobei zwischen Beschichtungsvorrichtung und Substrat eine Blende mit einer Blendenöffnung angeordnet ist. Diese Blende gewährleistet, dass nur ein dafür vorgesehener Bereich des Substrats direkt vom Gas der Beschichtungsvorrichtung erreicht wird. So kann z. B. ein Teil des Substratträgers (falls ein solcher eingesetzt wird) einer direkten Beschichtung entzogen werden. Das überschüssige Gas wird so vorteilhaft zu großen Teilen von der Gasabsaugung aus der Behandlungskammer entfernt, bevor es die Blendenöffnung passieren kann.

Als Beschichtungsvorrichtung wird bevorzugt mindestens ein Magnetron eingesetzt, dass sich in stabförmiger Bauweise über die gesamte Breite des Substrats erstreckt. Weitere bevorzugte Ausführungsformen sehen mehrere Magnetrons in Reihenanordnung vor, die die stabförmige Bauform ausbilden.

Weitere Schwerpunkte der Verwendung der erfindungsgemäßen Gasabsaugevorrichtung liegen bevorzugt in weiteren Plasmabearbeitungsanlagen. Hierbei kann es sich um Oberflächenverfahren wie Reinigen, Aktivieren, Funktionalisieren, Plasmaätzen und Beschichten handeln. Es werden vorwiegend skalierbare Plasmaquellen eingesetzt. Diese können entweder linear- oder auch flächenhaft skalierbar sein. Der Arbeitsdruckbereich liegt bei etwa 10⁻² mbar bis zu einigen mbar. Der abzuführende Gesamtgasfluss kann zwischen einigen sccm (Standardkubikzentimeter pro Minute) und einigen tausend sccm liegen.

Die Bearbeitungsgebiete in den Plasmabearbeitungsanlagen können hierbei auch unterschiedliche Bearbeitungsverfahren nutzen. Also z. B. Vorreinigung und Beschichten. Es können vorteilhaft reaktive Prozesse gegenüber nicht reaktiven Prozessen getrennt werden. Auch die Trennung von unterschiedlichen Dotierstoffbereichen usw. ist möglich. Gemeinsam mit den Bearbeitungsquellen soll insgesamt eine definierte Prozessumgebung geschaffen werden. Gleichzeitig soll die definierte Gasströmungsbeeinflussung in bevorzugten Ausführungsformen so auch eine Gasseparation ermöglichen.

Bei einem Einsatz der erfindungsgemäßen Gasabsaugvorrichtung mit Sputtermagnetrons oder auch Ionenstrahlquellen liegt der Druckbereich bei einigen 10⁻⁴ mbar bis zu etwa 10⁻² mbar. Der Gesamtgasfluss ist dabei normalerweise deutlich niedriger als in Plasmabearbeitungsanlagen.

Mit den unterschiedlichen Arbeitsdrücken und Gesamtgasflüssen ergeben sich dann auch unterschiedliche Dimensionierungen der Gasseparationsvorrichtung in dem Fachmann geläufiger Weise (Strömungsberechnung) Im Zuge der technischen Realisierung werden entsprechende angepasste Pumptechniken eingesetzt.

Insbesondere in Kombination mit optionalen Strömungswiderstandselementen, die Beschichtungsbereiche innerhalb einer Beschichtungskammer voneinander trennen, kann die erfindungsgemäße Gasabsaugung genutzt werden, um unterschiedliche Beschichtungsbereiche ohne mechanische Trennung, wie bspw. Zwischenwände oder Schleusen, zu betreiben.

### Ausführungsbeispiel

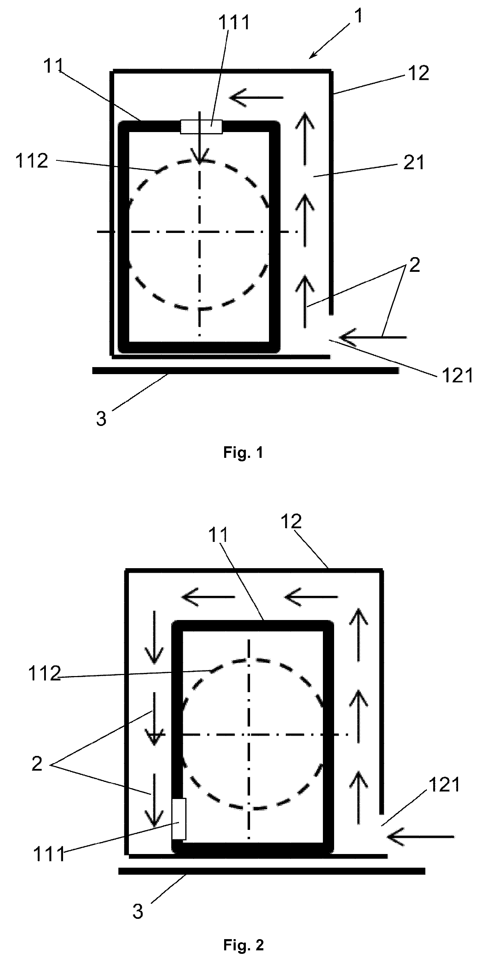

Das Ausführungsbeispiel bezieht sich auf die in der Figur Fig. 1 dargestellte Ausführungsform.

Der Querschnitt des Innenrohres (11) ist rechteckig und weist Abmessungen von 8 cm x 14 cm auf. Das Außenrohr ist im Zwischenraum (21) ca. 15 mm vom Innenrohr entfernt. Die Öffnungsweite der Ansaugöffnung (121) des Außenrohres beträgt 12 mm. die Ansaugöffnung (121) zieht sich über die gesamte Länge des Außenrohres (12). Das Innenrohr ist aus einem Standard-Rechteckrohr aus Edelstahlblech angefertigt. Dessen Wanddicke ist ca. 2mm. Das Außenrohr (12) besteht aus Edelstahlblech (Blechdicke ca. 1 mm). Etwa mittig zur Länge des Innenrohres (11) sind zwei nebeneinander angeordnete Ansaugöffnungen (111) vorhanden. Ein nicht dargestelltes Zwischenblech trennt das Innenrohr (11) radial, in der Mitte seiner Gesamtlänge, in zwei separat gepumpte Rohrabschnitte. Der Abstand der Ansaugöffnungen zueinander ist ca. 60mm. Die Öffnungsweite jeder Einsaugöffnung (111) beträgt dabei etwa 30 mm und deren Länge 250mm.Die Gesamtlänge der Vorrichtung ist ca. 100cm. Über die Anschlussöffnung (112) der Vakuumpumpe wird ein Unterdruck von 0,1 mbar bis 0, 5 mbar im Innenraum des Innenrohres (11) hergestellt. Der abgesaugte Volumenstrom beträgt 1000 sccm - 2000 sccm (sccm - Standardkubikzentimeter). Durch die spezielle Gestaltung und Anordnung der Einsaugöffnungen (111) wird ein leicht zur Mitte verstärkter Gasstrom (2) erreicht.

### Figuren

**Fig. 1** zeigt schematisiert eine Ausführungsform der erfindungsgemäßen Gasabsaugung (1). Die Gasabsaugvorrichtung (1) ist oberhalb des Substrates (3) angeordnet. Der Gasstrom (2) wird durch den Unterdruck im Zwischenraum (21) zwischen dem Außenrohr (12) und dem Innenrohr (11) in diesen hineingezogen. Kennzeichnend ist, dass die Ansaugöffnung (121) so ausgerichtet ist, dass der Gasstrom (2) parallel zur Substratoberfläche verläuft und nicht senkrecht zu dieser. Der Zwischenraum (21) ist in Umfangsrichtung labyrinthartig ausgeführt. Der Gasstrom (2) muss mehrere Umlenkungen überwinden, um zur Einsaugöffnung (111) des Innenrohres zu gelangen. Durch diese Umlenkungen wird ein erhöhter Strömungswiderstand in radialer Richtung im Zwischenraum (21) erzielt. Demgegenüber existiert in axialer Richtung (senkrecht zur Darstellungsebene) der Absaugvorrichtung kein Labyrinth. Dadurch findet ein Druckausgleich in axialer Richtung im Zwischenraum (21) statt, der einen über die gesamte Länge der Ansaugöffnung (121) gleichmäßigen Ansaugunterdruck zur Folge hat. Nach dem Passieren der Einsaugöffnung (111) des Innenrohres (11) wird der Gasstrom (21) an den beiden Enden des Innenrohres (11) durch Anschlussöffnungen (112) von Pumpen abgesaugt. Die dargestellte Einsaugöffnung (111) und Ansaugöffnung (121) bestehen aus mehreren schlitzartigen oder lochartigen Öffnungen, deren Anordnungen und Geometrie sich aus Strömungsberechnungen und/oder technischen Optimierung ergeben.
**Fig. 2** zeigt schematisiert eine weitere Ausführungsform der erfindungsgemäßen Gasabsaugung. Das Labyrinth, im Zwischenraum (21) zwischen Innenrohr (11) und Außenrohr (12) ist durch eine weitere Umlenkung des Gasstromes (21) komplexer gestaltet. Dies erhöht den möglichen Strömungswiderstand auf engstem Raum und verbessert den axialen Druckausgleich im Zwischenraum (21) weiter.

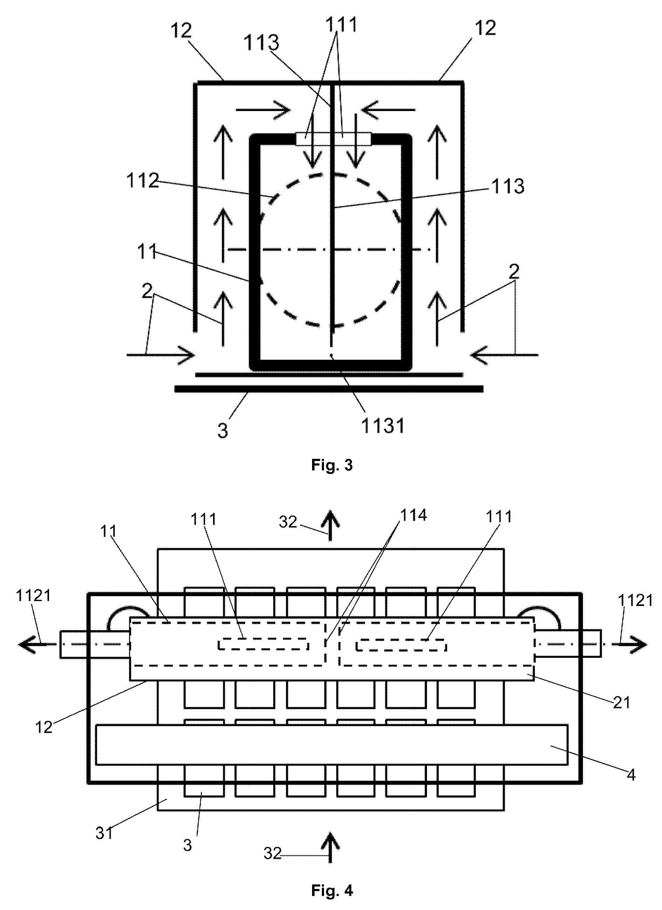

**Fig. 3** zeigt schematisch eine Konstruktion, die mittels eines gemeinsamen Innenrohres (11) eine Gasabsaugung (1) aus zwei Richtungen ermöglicht. Die Gasabsaugung kann so als Gasseparation wirken, da der Übertritt von Gas von einer Seite der Gasabsaugung (1) auf die andere verhindert wird. Die Erzeugung des Unterdrucks im Innenrohr (11) erfolgt mittels einer Vakuumpumpe, die beide Teile des durch die Zwischenwand (113) getrennten Innenrohres evakuiert. In besonderen Fällen kann die Zwischenwand (113) auch weggelassen werden. Dann sinkt zwar die Gasseparation zu benachbarten Bearbeitungseinrichtungen etwas ab, die Gasabsaugung ist aber weiterhin sehr effektiv.
**Fig. 4** zeigt schematisch die Sicht in Richtung Substratoberfläche. Die Substrate werden in Transportrichtung (32) unter der Gasabsaugung (1) hindurch gefahren. Die Substrate (3), hier als rechteckige Wafer dargestellt, sind in einem Substratträger (31) angeordnet. Die Beschichtungsvorrichtung (4) enthält mindestens eine, hier nicht dargestellte, eigene Gaszuführungsvorrichtung. Das überschüssige Gas, das nicht von der Beschichtungsvorrichtung auf der Substratoberfläche niedergeschlagen wird, wird durch die erfindungsgemäße Gasabsaugvorrichtung (1) aus der Beschichtungskammer abgezogen. Das Innenrohr ist in zwei Rohrabschnitte aufgeteilt, die jeweils getrennt voneinander durch eine Zwischenwand (114) abgeschlossen sind. Jeder Abschnitt des Innenrohres (11) weist jeweils eine Einsaugöffnung (111) auf. Aus jedem Abschnitt des Innenrohrs (11) wird an dem der Wandung der Beschichtungskammer nächstgelegenen Ende ein Absaugstrom (1121) abgezogen.

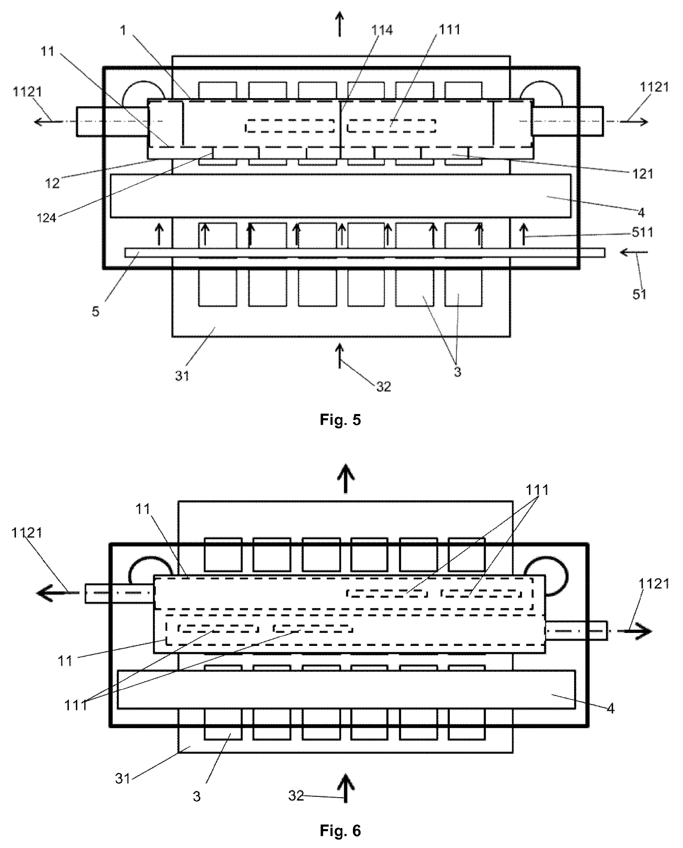

**Fig. 5** zeigt schematisch ebenfalls die Sicht in Richtung Substratoberfläche. Die Substrate werden in Transportrichtung (32) unter der Gasabsaugung (1) hindurch gefahren. Die Substrate (3), hier als rechteckige Wafer dargestellt, sind in einem Substratträger (31) angeordnet. Über die Gaszuführungsvorrichtung (5) wird ein Gasstrom (511) in den Raum zwischen Substratoberfläche und die Beschichtungsvorrichtung (4) injiziert. Das überschüssige Gas, das nicht von der Beschichtungsvorrichtung auf der Substratoberfläche niedergeschlagen wird, wird durch die erfindungsgemäße Gasabsaugvorrichtung (1) aus der Beschichtungskammer abgezogen. Das Außenrohr 12 weist dazu Ansaugöffnungen (121) auf, die voneinander durch Strömungsleitbleche (124) getrennt sind. Damit wird eine zusätzliche Zwangsführung des Gasstromes und eine Separation der Pumpwirkung auf einzelne Bereiche der Ansaugöffnung (121) erreicht. Die Zwischenwand 114 (teilt) sowohl das Außenrohr (12) als auch das Innenrohr (11) in zwei Rohrabschnitte, die getrennte Absaugcharakteristika aufweisen. Jeder Abschnitt des Innenrohres (11) weist jeweils eine Einsaugöffnung (111) auf. Aus jedem Abschnitt des Innenrohrs (11) wird an dem der Wandung der Beschichtungskammer nächstgelegenen Ende ein Absaugstrom (1121) abgezogen.
**Fig. 6** zeigt schematisch die Sicht in Richtung Substratoberfläche. Die Substrate werden in Transportrichtung (32) unter der Gasabsaugung (1) hindurch gefahren. Die Substrate (3), hier als rechteckige Wafer dargestellt, sind in einem Substratträger (31) angeordnet. Über die Gaszuführungsvorrichtung, der Beschichtungsvorrichtung (4) wird ein Gasstrom in den Raum zwischen Substratoberfläche und die Beschichtungsvorrichtung (4) injiziert. Das überschüssige Gas, das nicht von der Beschichtungsvorrichtung auf der Substratoberfläche niedergeschlagen wird, wird durch die erfindungsgemäße Gasabsaugvorrichtung (1) aus der Beschichtungskammer abgezogen. Innerhalb des Außenrohres (12) befinden sich zwei, in Transportrichtung (32), hintereinander liegende, getrennte Innenrohre (11). Jeder Abschnitt des Innenrohres (11) weist jeweils eine Einsaugöffnung (111) auf. Aus jedem Abschnitt des Innenrohrs (11) wird an dem der Wandung der Beschichtungskammer nächstgelegenen Ende ein Absaugstrom (1121) abgezogen. Durch die versetzte Anordnung der Innenrohre (11) und einer angepassten Lage der Ansaugöffnungen (111) können sich gegenseitig überlagernde Ansaugströme im Bezug zu den Substraten (3) erreicht werden.

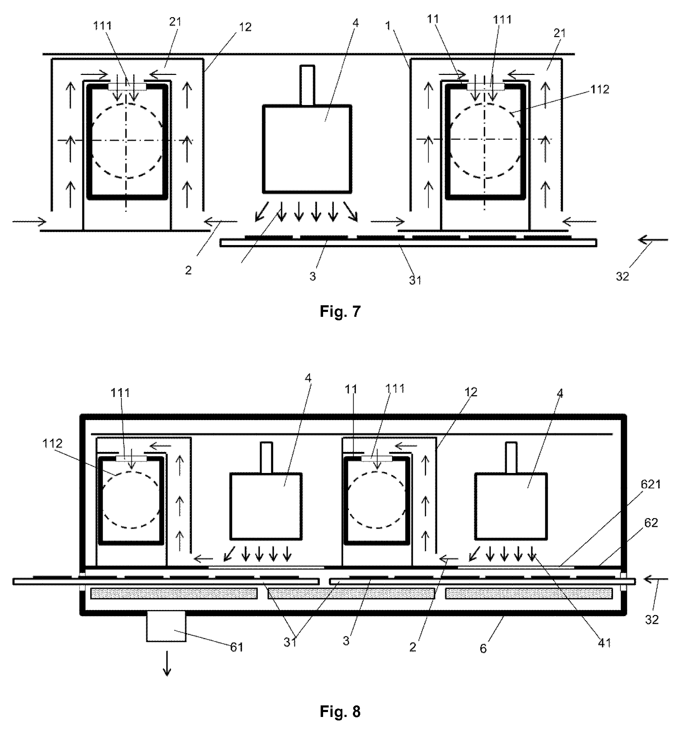

**Fig. 7** zeigt schematisch, wie die erfindungsgemäße Gasabsaugung in Verbindung mit einer Beschichtungsvorrichtung (4) eingesetzt wird. Die Substrate (3) werden unter der Beschichtungsvorrichtung (4) horizontal vorbei bewegt. Das aus der Beschichtungsvorrichtung (4) austretende Beschichtungsmaterial ist gasförmig und schlägt sich auf den Substrat (3) nieder. Überschüssiges Beschichtungsmaterial wird durch die beiden Gasabsaugungen (1), die sich in Transportrichtung (32) gesehen vor und hinter der Beschichtungsvorrichtung (4) befinden, parallel zur Substratoberfläche abgesaugt. Die Gasabsaugungen (1) ist dabei so konstruiert, dass ein Außenrohr (12) Öffnungen zu zwei benachbarten Beschichtungsvorrichtungen (4) aufweist. Dies ist besonders vorteilhaft, wenn die Gase der benachbarten Beschichtungsvorrichtungen identisch sind oder zumindest nicht miteinander reagieren.
**Fig. 8** zeigt schematisch eine Ausführungsform, bei der jeder Beschichtungsvorrichtung (4) eine Gasabsaugung (1) zugeordnet ist. Zwischen der Beschichtungsvorrichtung (4) und der Oberfläche des Substrates (3) ist eine Blende (62) angeordnet, die eine Öffnung (621) aufweist. Auf diese Weise wird sichergestellt, dass der überwiegende Teil des Beschichtungsmaterials auf dem Substrat (3) und nicht auf den Randbereichen des Substratträgers (31) abgeschieden wird. Außerdem kann die Öffnungsgeometrie der Blende (62) so angepasst werden, dass besonders homogene Schichtabscheidungen hinsichtlich Schichtdickenhomogenität als auch der Schichtzusammensetzung erreicht werden.

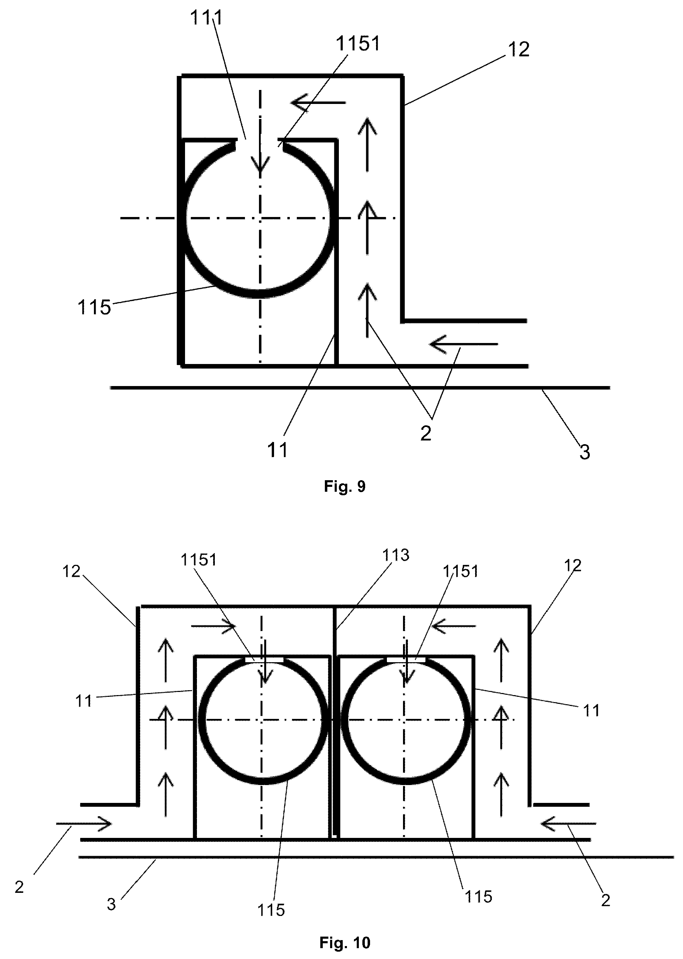

**Fig. 9** zeigt schematisch die Ausgestaltung der erfindungsgemäßen Gasabsaugung mit einem Innenrohr (11), das eine kreisförmige Querschnittfläche besitzt. Das Innenrohr (11) wird dabei von einer rechteckförmigen Leitblechanordnung (115) eingehüllt. In der Darstellung sind die Einsaugöffnung (111) des Innenrohres (11) und die Öffnung (1151) der Leitblechanordnung (115) deckungsgleich. Durch ein axiales Verdrehen des Innenrohres (11) gegenüber der Leitblechanordnung (115) kann die gemeinsame, überlagerte Öffnungsgeometrie beider Öffnungen (111 u. 1151) definiert eingestellt werden. Damit kann z.B. eine wirkungsvolle Feinkorrektur des Gasströmungswiderstandes und damit auch des Gasströmungsprofiles erreicht werden. Die Leitblechanordnung (115) kann auch derartig ausgeführt werden, dass sie z. B. von der Substratseite her gesehen nur etwa bis zum Halbdurchmesser des Innenrohres (11) reicht. Damit hat die Leitblechanordnung quasi die Form eines U-Bleches, das z. B. seitlich an das Innenrohr (11) befestigt sein kann und das zur Substratseite einen geschlossenen Boden aufweist. Die Leitblechanordnung besitzt dann keine Öffnungen (1151).
**Fig. 10** zeigt die Konstruktion nach Fig. 9 in benachbarter, spiegelsymmetrischer Ausgestaltung. Auf diese Weise entsteht eine Gasabsaugung, die sowohl in Transportrichtung als auch entgegengesetzt absaugt, dabei jedoch für unterschiedliche Gasarten geeignet ist.

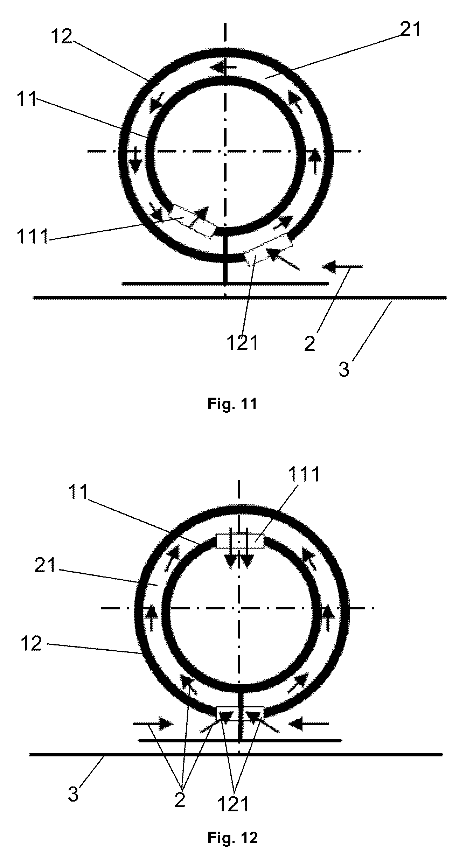

**Fig. 11** zeigt schematisch eine Rohr-in-Rohr Bauform mit Rohren mit rundem Querschnitt. Hier wird die Labyrinthbildung für die Gasströmung (2) realisiert, indem die Einsaugöffnung (111) des Innenrohres (11) so weit wie möglich von der Ansaugöffnung (121) des Außenrohres (12) entfernt ist.
**Fig. 12** zeigt schematisch die Ausgestaltung der erfindungsgemäßen Gasabsaugung mit Rohren mit runden Querschnitten, die zu der nach Fig. 11 äquivalent ist. Die Gasabsaugungen (1) ist hier jedoch so konstruiert, dass ein Außenrohr (12) eine geteilte Einsaugöffnung (121) zu zwei benachbarten Beschichtungsvorrichtungen (4) aufweist. Dies ist besonders vorteilhaft, wenn die Gase der benachbarten Beschichtungsvorrichtungen identisch sind oder zumindest nicht miteinander reagieren.

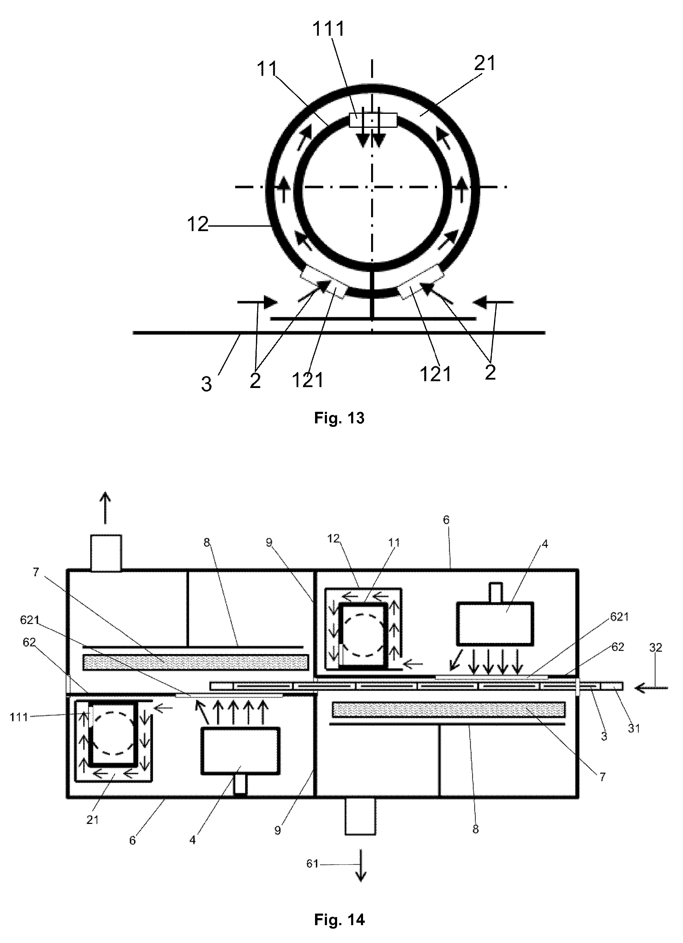

**Fig. 13** entspricht der Darstellung aus Fig. 12, wobei hier die Ansaugöffnung (121) nicht geteilt ist, sondern in jede Richtung zu einer benachbarten Beschichtungsvorrichtung eine eigene Ansaugöffnung (121) realisiert ist.
**Fig. 14** zeigt schematisch, wie die erfindungsgemäße Gasabsaugung in einer Beschichtungskammer (6) zur aufeinanderfolgenden Beschichtung der Vorder- und der Rückseite des Substrats (3) eingesetzt werden kann. Die Substrate (3) sind in einem Substratträger (31) gelagert und werden auf diesem in Transportrichtung (32) in die Beschichtungskammer (6) hineingefahren. Die Beschichtungsvorrichtung (4) ist von der Substratoberfläche durch eine Blende (62) mit einer Blendenöffnung (621) getrennt. Die Blendenöffnung (621) gibt die zu beschichtenden Bereiche (die Substrate) frei und verdeckt bspw. große Teile des Substratträgers (bspw. den äußeren Rahmen) dessen Beschichtung unerwünscht ist. Darüber hinaus bewirkt die Blende eine Erhöhung des Strömungswiderstandes zwischen Substratoberseite und Blende. Dadurch wird überschüssiges Gas leichter von der erfindungsgemäßen Gasabsaugung erfasst und aus der Beschichtungskammer (6) entfernt, ehe es bis in den Bereich der Beschichtung der Unterseite des Substrates (3) vordringen kann. Der Substratträger (31) mit den Substraten (3) wird nunmehr in den Teil der Beschichtungskammer (6) weiterbewegt, in dem die Rückseite der Substrate (3) beschichtet wird. Dieser Teil ist prinzipiell mit dem Teil zur Beschichtung der Oberseite identisch, beschichtet wird jedoch von unten. Auch hier sorgt der durch die Blende erhöhte Strömungswiderstand dafür, dass das Beschichtungsgas für die Unterseite nicht oder kaum in den Beschichtungsbereich für die Oberseite vordringen kann. In der dargestellten Bauform werden die Beschichtungsbereiche zur Beschichtung der Ober- und der Unterseite getrennt voneinander über eigene Vakuumerzeugungen (61) evakuiert. Die Beschichtungsbereiche werden in der Beschichtungskammer (6) durch eine Zwischenwand (9) getrennt. Zur Temperierung der Substrate (3) und des Substratträgers (31) sind Heizplatten (7) vorgesehen. Strahlenschilde (8) sorgen für eine effektive Heizwirkung in Richtung der Substratträger (31) und reduzieren mögliche Strahlungsverluste zu den Kammerwänden.

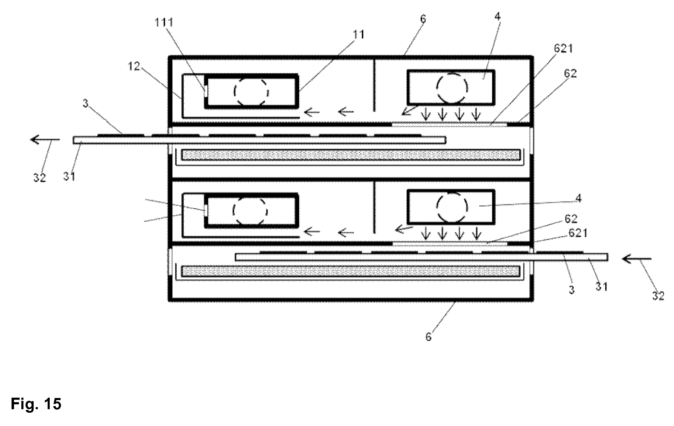

**Fig. 15** zeigt schematisch eine besonders Stellplatzsparende Ausführungsform der Beschichtungsvorrichtung. Es sind zwei Behandlungskammern (6) übereinander angeordnet. Auch hier sind die Substrate (3) durch Blenden (62) von der Beschichtungsvorrichtung (4) getrennt. Hier zeigt sich beispielhaft der Vorteil der erfindungsgemäßen Ausgestaltung der Gasabsaugung mit einer axialen Anordnung von Abpumpvorrichtungen zur Kammerwand der Behandlungskammer (6).

Prinzipiell sind die wesentlichsten Merkmale der beschriebenen Figuren auch miteinander kombinierbar. Innerhalb einer Bearbeitungskammer können mehrere gleiche oder auch unterschiedliche erfindungsgemäße Gasabsaugungsvorrichtungen eingesetzt werden. Es können auch mehrere Bearbeitungskammern nacheinander zu einem komplexeren Bearbeitungssystem zusammengefügt werden. Die unterschiedlich möglichen Funktionen der erfindungsgemäßen Absaugvorrichtung wie eine definierte Gasabsaugung, eine Gasströmungsprofilanpassung bzw. eine Gasseparation können einzeln oder auch kombiniert realisiert werden.

### Bezugszeichenliste

- 1: Gasabsaugvorrichtung
- 11: Innenrohr
- 111: Einsaugöffnung des Innenrohrs
- 112: Anschlussöffnung der Vakuumpumpe
- 1121: Absaugstrom der Vakuumpumpe aus dem Innenrohr
- 113: axiale Zwischenwand im Innenrohr
- 1131: Öffnung in der axialen Zwischenwand im Innenrohr
- 114: radiale Zwischenwand im Innenrohr
- 115: Leitblechanordnung
- 1151: Öffnung an der Leitblechanordnung
- 12: Außenrohr
- 121: Ansaugöffnung des Außenrohres
- 123: axiale Zwischenwand im Außenrohr124 Strömungsleitbleche
- 2: Gasströmung
- 21: Zwischenraum zwischen Innenrohr und Außenrohr
- 3: Substrat
- 31: Substratträger
- 32: Transportrichtung
- 4: Beschichtungsvorrichtung
- 41: Beschichtungsgas
- 42: Plasma
- 5: Gaszuführungsvorrichtung
- 51: zuströmendes Gas
- 511: Gaszustrom in der Beschichtungskammer
- 6: Beschichtungskammer
- 61: Vakuumerzeugung der Beschichtungskammer
- 62: Blende
- 621: Öffnung der Blende
- 7: Heizplatte
- 8: Strahlungsschild
- 9: Zwischenwand in der Beschichtungskammer

## Patentansprüche

1. Vorrichtung zur Gasbewegung in Vakuum-Beschichtungsanlagen, aufweisend
- mindestens eine Beschichtungskammer mit mindestens einem Beschichtungsbereichen,
- eine Transportvorrichtung zum Transport flächiger Substrate in eine Transportrichtung in die Beschichtungskammer und zur Halterung der Substrate in dieser,
- mindestens eine Beschichtungsvorrichtung je Beschichtungsbereich, die gasförmiges Beschichtungsmaterial absondert, wobei die Länge der Beschichtungsvorrichtung mindestens der Breite des Substrats entspricht,
- mindestens eine Absaugvorrichtung je Beschichtungsbereich, wobei die Absaugvorrichtung
o sich im Wesentlichen parallel zu der Beschichtungsvorrichtung erstreckt sowie mindestens deren Länge aufweist,
o mindestens an eine Pumpe angeschlossen ist, die geeignet ist, im Inneren der Absaugvorrichtung einen Unterdruck gegenüber den Innendruck der Beschichtungskammer zu erzeugen,
**dadurch gekennzeichnet, dass**
- die mindestens eine Pumpe in axialer Verlängerung der Absaugvorrichtung an diese angeschlossen ist,
- die Absaugvorrichtung eine oder mehrere Ansaugöffnungen aufweist,
- die Absaugvorrichtung mindestens zwei axiale Bereiche aufweist, deren Absaugcharakteristika weitgehend getrennt voneinander einstellbar sind.

2. Vorrichtung nach Anspruch 1, **dadurch gekennzeichnet, dass** im Inneren der Absaugvorrichtung mindestens eine Diffusoreinrichtung vorgesehen ist.

3. Vorrichtung nach Anspruch 2 **dadurch gekennzeichnet, dass** die Diffusoreinrichtung ein Labyrinth ist, das so gestaltet ist, dass es in linearer Richtung der Absaugvorrichtung einen Druckverlust aufweist, der sehr viel kleiner ist, als der Druckverlust in Umfangsrichtung.

4. Vorrichtung nach Anspruch 3, **dadurch gekennzeichnet, dass** das Labyrinth gebildet wird, indem im Inneren der Absaugvorrichtung ein Innenrohr angeordnet ist, an das die mindestens eine Pumpe angeschlossen ist und das entlang seiner Längserstreckung eine oder mehrere Einsaugöffnungen aufweist, die von den Ansaugöffnungen weggerichtet sind.

5. Vorrichtung nach Anspruch 4, **dadurch gekennzeichnet, dass**, die Einsaugöffnungen in ihrer Öffnungsweite veränderbar sind.

6. Vorrichtung nach Anspruch 4, **dadurch gekennzeichnet, dass** das Innenrohr entlang seiner gesamten Länge tordierbar ist.

7. Vorrichtung nach Anspruch 6, **dadurch gekennzeichnet, dass** das Innenrohr an mindestens einer Stelle mittels einer Zwischenwand mit dem Außenrohr starr verbunden ist, und die dabei entstehenden Innenrohrabschnitte des Innenrohres unabhängig voneinander in Umfangsrichtung tordiert werden können

8. Vorrichtung nach Anspruch 3, **dadurch gekennzeichnet, dass** das Labyrinth gebildet wird, indem im Inneren der Absaugvorrichtung ein Innenrohr angeordnet ist, das Innenrohr durch eine Trennwand unterteilt ist und die Absaugung durch jeweils an einem Ende des Innenrohrs angeordnete Pumpen erfolgt.

9. Vorrichtung nach Anspruch 8, **dadurch gekennzeichnet, dass** die Trennwand annähernd mittig angeordnet und/oder axial verschiebbar ist.

10. Vorrichtung nach Anspruch 8, **dadurch gekennzeichnet, dass** die Trennwand axial feststehend angeordnet ist, und das Innenrohr dadurch in zwei Innenrohrabschnitte aufgeteilt wird.

11. Vorrichtung nach Anspruch 10, **dadurch gekennzeichnet, dass** die Innenrohrabschnitte getrennt voneinander um ihre Längsachse gedreht werden können.

12. Vorrichtung nach Anspruch 10, **dadurch gekennzeichnet, dass** die Innenrohrabschnitte tordierbar sind und getrennt voneinander in Umfangsrichtung verdreht werden können.

13. Vorrichtung nach einem der vorhergehenden Ansprüche **dadurch gekennzeichnet, dass** die Absaugvorrichtung an ihrer Außenseite Strömungsleitbleche aufweist, die feststehend oder an der Absaugvorrichtung axial verschiebbar sind.

14. Vorrichtung nach Anspruch 4, **dadurch gekennzeichnet, dass** das Innenrohr auf seiner Außenseite Strömungsleitbleche trägt, die die durch die Einsaugöffnungen verlaufende Strömung beeinflussen und feststehend oder axial auf dem Innenrohr verschiebbar sind.

15. Vorrichtung nach einem der vorhergehenden Ansprüche, **dadurch gekennzeichnet, dass** das Innenrohr mit mindestens einem Drehantrieb versehen ist, der das Innenrohr vollständig oder abschnittsweise im Zeitverlauf einer Behandlung der Substrate um seine Längsachse verdreht.

## Claims

1. Device for gas movement in vacuum-coating systems, comprising
- at least one coating chamber with at least one coating area,
- a transport device to transport flat substrates in a direction of transport into the coating chamber and to hold the substrates in it,
- at least one coating device per coating area that gives off gaseous coating material, wherein the length of the coating device is equal to at least the width of the substrate,
- at least one suction device per coating area, wherein the suction device
o essentially extends in parallel to the coating device and has at least the length of it,
o at least one connected pump that is suitable for generating a low pressure vis-a-vis the internal pressure of the coating chamber in the interior of the suction device,
**characterized in that**
- the at least one pump is connected to the suction device in an axial extension of it,
- the suction device has one or more suction openings,
- the suction device has at least two axial areas whose suction characteristics can be adjusted separately from one another to a great extent.

2. Device according to claim 1, **characterized in that** at least one diffusor unit is provided in the interior of the suction device.

3. Device according to claim 2, **characterized in that** the diffusor unit is a labyrinth that is structured in such a way that it has a pressure loss in the linear direction of the suction device that is very much smaller than the pressure loss along the circumference.

4. Device according to claim 3, **characterized in that** the labyrinth is formed by putting an internal tube in the interior of the suction device that at least one pump is connected to and that has one or more intake openings along its longitudinal extension that are facing away from the suction openings.

5. Device according to claim 4, **characterized in that** the intake openings can be changed in terms of their opening widths.

6. Device according to claim 4, **characterized in that** the internal tube can be twisted over its entire length.

7. Device according to claim 6, **characterized in that** the internal tube is rigidly connected in at least one place to the external tube via an intermediate wall, and the internal-tube sections of the internal tube that arise in the process can be twisted along the circumference independently of one another.

8. Device according to claim 3, **characterized in that** the labyrinth is formed by putting an internal tube in the interior of the suction device, dividing the internal tube with a partition wall and providing suction via pumps arranged at each end of the internal tube.

9. Device according to claim 8, **characterized in that** the partition wall is positioned roughly in the middle and/or can be axially moved.

10. Device according to claim 8, **characterized in that** the partition wall is axially fixed in place and the internal tube is divided up into two internal-tube sections because of that.

11. Device according to claim 10, **characterized in that** the internal-tube sections can be rotated along their longitudinal axes separately from one another.

12. Device according to claim 10, **characterized in that** the internal-tube sections can be twisted and rotated along the circumference separately from one another.

13. Device according to one of the preceding claims, **characterized in that** the suction device has flow guide plates on the outside which are fixed or which can be moved axially on the suction device.

14. Device according to claim 4, **characterized in that** the internal tube has flow guide plates on its outside that influence the flow running through the intake openings which are fixed or which can be moved axially on the internal tube.

15. Device according to one of the preceding claims, **characterized in that** the internal tube is provided with at least one rotary drive that rotates the internal tube around its longitudinal axis completely or in sections in the course of a treatment of the substrates.

## Revendications

1. Dispositif destiné à déplacer des gaz dans des installations de revêtement sous vide, comportant
- au moins une chambre de revêtement avec au moins une zone de revêtement,
- un dispositif de transport pour transporter des substrats plans dans une direction de transport dans la chambre de revêtement et pour maintenir le substrat dans cette dernière,
- au moins un dispositif de revêtement par zone de revêtement, qui sépare de la matière de revêtement gazeuse, la longueur du dispositif de revêtement correspondant au moins à la largeur du substrat,
- au moins un dispositif d'aspiration par zone de revêtement, le dispositif d'aspiration
∘ s'étendant sensiblement à la parallèle du dispositif de revêtement et présentant au moins la longueur de celui-ci,
∘ étant raccordé au moins sur une pompe qui est apte à générer à l'intérieur du dispositif d'aspiration une dépression par rapport à la pression intérieure de la chambre de revêtement,
**caractérisé en ce que**
- l'au moins une pompe est raccordée sur le dispositif d'aspiration dans le prolongement axial de celui-ci,
- le dispositif d'aspiration comporte un ou plusieurs orifices d'aspiration,
- le dispositif d'aspiration comporte au moins deux zones axiales, dont les caractéristiques d'aspiration sont réglables de manière largement séparée l'une de l'autre.

2. Dispositif selon la revendication 1, **caractérisé en ce qu'**à l'intérieur du dispositif d'aspiration est prévu au moins un système de diffuseur.

3. Dispositif selon la revendication 2, **caractérisé en ce que** le système de diffuseur est un labyrinthe qui est conçu de sorte à présenter en direction linéaire du dispositif d'aspiration une perte de pression qui est très nettement inférieure à la perte de pression en direction périphérique.

4. Dispositif selon la revendication 3, **caractérisé en ce que** le labyrinthe est formé **en ce qu'**à l'intérieur du dispositif d'aspiration est placé un tube intérieur auquel est raccordée l'au moins une pompe et qui le long de son extension longitudinale comporte un ou plusieurs orifices d'imbibition qui sont dirigés en s'éloignant des orifices d'aspiration.

5. Dispositif selon la revendication 4, **caractérisé en ce que** les orifices d'imbibition ont une largeur d'ouverture variable.

6. Dispositif selon la revendication 4, **caractérisé en ce que** le tube intérieur peut être tordu le long de toute sa longueur.

7. Dispositif selon la revendication 6, **caractérisé en ce que** sur au moins un endroit, le tube intérieur est relié de manière rigide au moyen d'une paroi intermédiaire avec le tube extérieur et les tronçons de tube intérieur qui en résultent peuvent être tordus en direction périphérique, indépendamment les uns des autres.

8. Dispositif selon la revendication 3, **caractérisé en ce que** le labyrinthe est formé **en ce qu'**à l'intérieur du dispositif d'aspiration est placé un tube intérieur, le tube intérieur est divisé par une paroi de séparation et l'aspiration s'effectue par des pompes placées chaque fois sur une extrémité du tube intérieur.

9. Dispositif selon la revendication 8, **caractérisé en ce que** la paroi de séparation est placée approximativement au centre et/ou déplaçable en direction axiale.

10. Dispositif selon la revendication 8, **caractérisé en ce que** la paroi de séparation est placée de manière stationnaire en direction axiale et de ce fait, le tube intérieur est divisé en deux tronçons de tube intérieur.

11. Dispositif selon la revendication 10, **caractérisé en ce que** les tronçons de tube intérieur peuvent se tourner séparément l'un de l'autre autour de leur axe longitudinal.

12. Dispositif selon la revendication 10, **caractérisé en ce que** les tronçons de tube intérieur peuvent se tordre et se tourner indépendamment l'un de l'autre en direction périphérique.

13. Dispositif selon l'une quelconque des revendications précédentes, **caractérisé en ce que** sur sa face extérieure, le dispositif d'aspiration comporte des tôles de guidage d'écoulement, qui sont stationnaires ou déplaçables en direction axiale sur le dispositif d'aspiration.

14. Dispositif selon la revendication 4, **caractérisé en ce que** sur sa face extérieure, le tube intérieur comporte des tôles de guidage d'écoulement qui influencent l'écoulement s'écoulant à travers les orifices d'imbibition et qui sont stationnaires ou déplaçables en direction axiale sur le tubé intérieur.

15. Dispositif selon l'une quelconque des revendications précédentes, **caractérisé en ce que** le tube intérieur est muni d'au moins un entraînement en rotation qui fait tourner le tube intérieur complètement ou par tronçons autour de son axe longitudinal, au cours d'un traitement des substrats.
